# EUROPEAN PATENT APPLICATION

(11) **EP 4 289 995 A1**
(43) Date of publication of application: **13.12.2023**
(21) Application number: 22749450.7
(22) Date of filing: 17.01.2022
(51) Int. Cl.: C30B 25/18, H01L 21/20, H01L 21/205, C30B 29/38

(54) **NITRIDE SEMICONDUCTOR SUBSTRATE AND METHOD FOR PRODUCING SAME**

(30) Priority: 05.02.2021 JP 2021017760
(71) Applicant: Shin-Etsu Handotai Co., Ltd., Tokyo 100-0004 (JP)
(72) Inventor: KUBONO, Ippei, Annaka-shi, Gunma 379-0196 (JP); TSUCHIYA, Keitaro, Annaka-shi, Gunma 379-0196 (JP); HAGIMOTO, Kazunori, Annaka-shi, Gunma 379-0196 (JP); SHINOMIYA, Masaru, Annaka-shi, Gunma 379-0196 (JP)
(74) Representative: Sonnenhauser, Thomas Martin
(86) International application number: PCT/JP2022/001274
(87) International publication number: WO 2022/168573

(57) **Abstract**

The present invention is a nitride semiconductor substrate, including a Ga-containing nitride semiconductor thin film formed on a substrate for film-forming in which a single crystal silicon layer is formed above a supporting substrate via an insulative layer, wherein the nitride semiconductor substrate has a region where the Ga-containing nitride semiconductor thin film is not formed inward from an edge of the single crystal silicon layer being a growth surface of the nitride semiconductor thin film. This provides: a nitride semiconductor substrate with inhibited generation of a reaction mark; and a manufacturing method therefor.

## Description

### TECHNICAL FIELD

The present invention relates to a nitride semiconductor substrate and manufacturing method therefor.

### BACKGROUND ART

A MOCVD method, which is one of methods for manufacturing a semiconductor thin film is commonly used because the method has excellent large-diameter formability and mass productivity and can form a uniform thin film crystal. Nitride semiconductors represented by GaN are promising as a next-generation semiconductor material beyond the limit of a Si material. For a substrate for epitaxially growing GaN, etc. in the MOCVD method, GaN, SiC, sapphire, Si, etc. are used.

In recent years, a substrate in which a single crystal silicon substrate is laminated onto an insulative layer (such as SiO₂) (hereinafter, described as "single crystal silicon substrate-on-insulative layer"), represented by SOI, is practically applied as a substrate for epitaxially growing GaN. For example, GaN/SOI can electrically isolate each discrete part, and this insulation method is proved to eliminate a back-gate effect (which is a variation of a threshold voltage of a MOSFET due to a voltage of the substrate) and reduce switching noise. Such characteristics are merits not exhibited with the Si substrate, the GaN substrate, etc. In addition, a substrate in which a plurality of layers covers a proximity of ceramic and an insulative layer and a thin Si substrate are present on the surface side has merits of: easy control of a warp in GaN growing by a thermal expansion coefficient close to that of GaN; and hardly generated cracking or braking.

However, the single crystal silicon substrate and the single crystal silicon substrate-on-insulative layer has a surface (GaN growth surface) made of Si, and thereby a eutectic reaction product (hereinafter, "reaction mark") between Si and Ga due to melt-back etching is likely to be generated. This reaction mark not only decreases a device yield but also probably becomes a dust source in a device process, which may contaminate a process line. Thus, it is extremely important to control generation of the reaction mark.

Accordingly, the generation of the reaction mark is basically prevented by using a layer such as AlN on the single crystal silicon substrate, but even in this case, the reaction mark may be generated on a several positions in the wafer substrate. Patent Document 1 discloses art for removing the reaction mark after the epitaxial growth of GaN, but does not disclose a method for controlling the reaction mark by making contrivance in the epitaxial growth.

Patent Document 2 discloses art about forming a III-V group semiconductor thin film on the single crystal silicon substrate-on-insulative layer (SiO herein), but do not describe a reduction in defects in the film formation. There has been no literature disclosing art about a reduction in defects in forming a nitride semiconductor thin film on the single crystal silicon substrate-on-insulative layer.

### CITATION LIST

### PATENT LITERATURE

Patent Document 1: JP 2015-170648 A
Patent Document 2: JP 2011-101007 A

### TECHNICAL PROBLEM

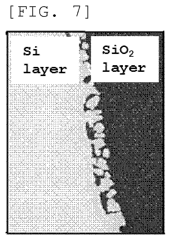

When GaN is epitaxially grown on the single crystal silicon substrate-on-insulative layer as above, Si in a surface layer of the single crystal silicon substrate-on-insulative layer and Ga in trimethylgallium (TMGa) used as a Ga source may be reacted to generate the reaction mark. Compared with GaN growth on the single crystal silicon substrate alone, GaN growth on the single crystal silicon substrate-on-insulative layer tends to be likely to generate the reaction mark. This is because an edge of the surface layer of the single crystal silicon layer on the single crystal silicon substrate-on-insulative layer, which has a complex shape (FIG. 7), causes a place where an AlN layer that is formed as an initial layer in forming the GaN epitaxial film is hardly formed, and bare Si is present on the edge of the single crystal silicon layer with a high possibility to be likely to allow Ga to be reacted with Si. An edge of the wafer and the edge of the single crystal silicon layer are not necessarily coincided, and the edge of the single crystal silicon layer is present inward within a certain range from the edge of the wafer in some cases. Thus, it is described as "the edge of the single crystal silicon layer".

The position where the reaction mark is generated may not only decrease the device yield but also may become a dust source in a device process to contaminate the process, and thereby the reduction is required.

The present invention has been made to solve the above problem. An object of the present invention is to provide: a nitride semiconductor substrate with inhibited generation of the reaction mark; and a manufacturing method therefor.

### SOLUTION TO PROBLEM

To solve the above problem, the present invention provides a nitride semiconductor substrate comprising a Ga-containing nitride semiconductor thin film formed on a substrate for film-forming in which a single crystal silicon layer is formed above a supporting substrate via an insulative layer, wherein the nitride semiconductor substrate has a region where the Ga-containing nitride semiconductor thin film is not formed inward from an edge of the single crystal silicon layer being a growth surface of the nitride semiconductor thin film.

Such a nitride semiconductor substrate can inhibit the generation of the reaction mark due to the eutectic reaction between the single crystal silicon and Ga.

In the present invention, the region where the film is not formed is preferably a region with 0.3 mm or longer and shorter than 3 mm inward from the edge of the single crystal silicon layer.

Such a nitride semiconductor substrate can more improve the effect of the present invention.

In the present invention, the insulative layer is preferably a silicon oxide (SiO₂) layer.

Such a nitride semiconductor substrate can eliminate the back-gate effect and inhibit the switching noise.

In the present invention, the nitride semiconductor thin film formed on the substrate for film-forming preferably has: an AlN film; and a GaN film or an AlGaN film, or a both thereof formed on the AlN film.

Such a nitride semiconductor substrate is useful as a nitride semiconductor substrate required in recent years, and can still further improve the effect of the present invention.

In the present invention, the substrate for film-forming preferably has: polycrystalline silicon or single crystal silicon as the supporting substrate; and the single crystal silicon layer laminated above the supporting substrate via a silicon oxide layer.

Such a nitride semiconductor substrate can further improve the effect of the present invention.

The present invention also provides a method for manufacturing a nitride semiconductor substrate, the method comprising steps of:
preparing at least a supporting substrate and a single crystal silicon substrate for laminating;
bonding the supporting substrate and the single crystal silicon substrate for laminating via a silicon oxide layer;
thinning the single crystal silicon substrate for laminating to be processed into a single crystal silicon layer;
placing a ring-shaped member so as to cover the single crystal silicon layer inward from an edge thereof;
growing an AlN film on the single crystal silicon layer; and
growing a GaN film or an AlGaN film, or both thereof on the AlN film.

Such a method for manufacturing a nitride semiconductor substrate can relatively easily manufacture the nitride semiconductor substrate with inhibited generation of the reaction mark due to the eutectic reaction between the single crystal silicon and Ga.

In the present invention, the supporting substrate is preferably a supporting substrate composed of polycrystalline silicon or single crystal silicon.

Such a method for manufacturing a nitride semiconductor substrate can further improve the effect of the present invention.

### ADVANTAGEOUS EFFECTS OF INVENTION

As noted above, the inventive nitride semiconductor substrate can inhibit the generation of the reaction mark due to the eutectic reaction between the single crystal silicon and Ga. Therefore, a high-quality nitride semiconductor substrate can be obtained, and in manufacturing a device using this substrate, improvement of a device yield and higher precision can be attempted.

### BRIEF DESCRIPTION OF DRAWINGS

FIG. 1 is a schematic image of a top view illustrating an example of the inventive nitride semiconductor substrate.
FIG. 2 is a schematic image illustrating an example of an MOCVD apparatus that can be used for the inventive method for manufacturing a nitride semiconductor substrate.
FIG. 3 is a schematic sectional view illustrating an example of a substrate for film-forming of the inventive nitride semiconductor substrate.
FIG. 4 shows a relationship between a change in a width of A illustrated in FIG. 1 and a number of generated reaction marks.
FIG. 5 is an observation image with an optical microscope showing an edge part of a substrate formed in Example.
FIG. 6 is an observation image with an optical microscope showing an edge part of a substrate formed in Comparative Example.
FIG. 7 is an observation image with an optical microscope showing an edge of a surface layer of a single crystal silicon layer.

### DESCRIPTION OF EMBODIMENTS

As noted above, there have been demands for development of a nitride semiconductor substrate with inhibited generation of the reaction mark and a manufacturing method therefor.

When GaN is epitaxially grown on the single crystal silicon substrate-on-insulative layer as above, the single crystal silicon in a surface layer of the substrate for growing GaN and Ga in trimethylgallium (TMGa) used as a Ga source may be reacted to generate the reaction mark.

The present inventors have made earnest study to solve the above problem, and have found that the generation of the reaction mark can be inhibited by providing a region where the Ga-containing nitride semiconductor thin film is not formed inward from an edge of the single crystal silicon layer being a growth surface of the nitride semiconductor thin film. This finding has led to complete the present invention.

Specifically, the present invention is a nitride semiconductor substrate comprising a Ga-containing nitride semiconductor thin film formed on a substrate for film-forming in which a single crystal silicon layer is formed above a supporting substrate via an insulative layer, wherein the nitride semiconductor substrate has a region where the Ga-containing nitride semiconductor thin film is not formed inward from an edge of the single crystal silicon layer being a growth surface of the nitride semiconductor thin film.

In addition, the present invention is a method for manufacturing a nitride semiconductor substrate, the method comprising steps of:
preparing at least a supporting substrate and a single crystal silicon substrate for laminating;
bonding the supporting substrate and the single crystal silicon substrate for laminating via a silicon oxide layer;
thinning the single crystal silicon substrate for laminating to be processed into a single crystal silicon layer;
placing a ring-shaped member so as to cover the single crystal silicon layer inward from an edge thereof;
growing an AlN film on the single crystal silicon layer; and
growing a GaN film or an AlGaN film, or both thereof on the AlN film.

Hereinafter, the present invention will be described in detail by using the drawings, but the present invention is not limited thereto.

### Nitride Semiconductor Substrate

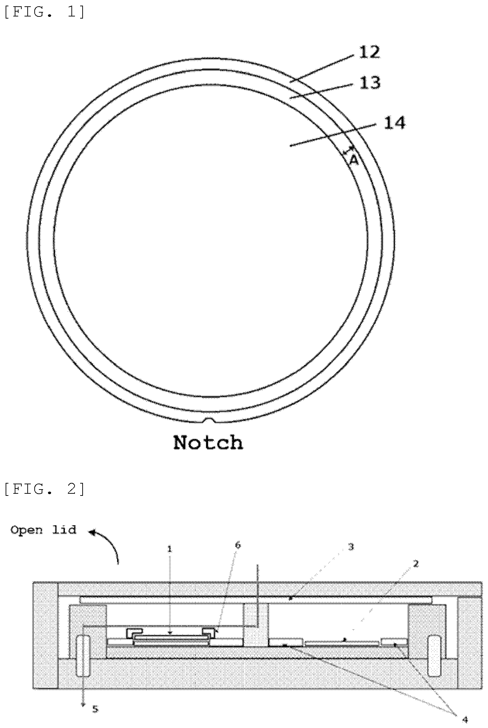

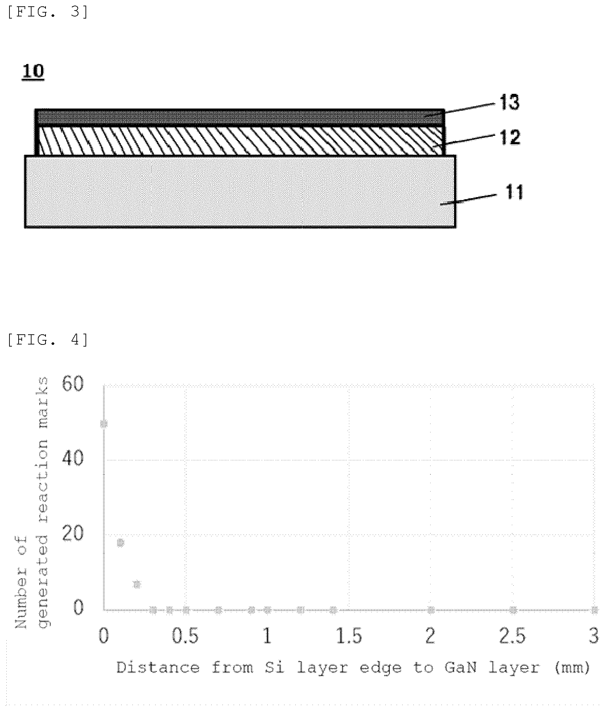

A constitution of the inventive nitride semiconductor substrate is, as illustrated FIG. 3, a nitride semiconductor substrate in which a Ga-containing nitride semiconductor thin film is formed on a substrate for film-forming 10 in which a single crystal silicon layer 13 is formed above a supporting substrate 11 via an insulative layer 12. As illustrated in FIG. 1, the inventive nitride semiconductor substrate has a region A where the Ga-containing nitride semiconductor thin film 14 is not formed inward from an edge of the single crystal silicon layer 13 being a growth surface of the nitride semiconductor thin film 14.

As illustrated in FIG. 3, the substrate for film-forming can be constituted by forming the single crystal silicon layer 13 above the supporting substrate 11 via the insulative layer 12.

A range A of the region where the film is not formed is not particularly limited, but preferably a region with 0.3 mm or longer and shorter than 3 mm inward from the edge of the single crystal silicon layer.

A material of the insulative layer is not particularly limited, but is preferably a silicon oxide (SiO₂) layer.

The nitride semiconductor thin film formed on the substrate for film-forming is not particularly limited, but preferably has: an AlN film; and a GaN film or an AlGaN film, or a both thereof formed on the AlN film.

In this case, the substrate for film-forming preferably has: polycrystalline silicon or single crystal silicon as the supporting substrate; and the single crystal silicon layer laminated above the supporting substrate via a silicon oxide layer.

### Method for Manufacturing Nitride Semiconductor Substrate

The inventive method for manufacturing a nitride semiconductor substrate is not particularly limited as long as it comprises steps of:
preparing at least a supporting substrate and a single crystal silicon substrate for laminating;
bonding the supporting substrate and the single crystal silicon substrate for laminating via a silicon oxide layer;
thinning the single crystal silicon substrate for laminating to be processed into a single crystal silicon layer;
placing a ring-shaped member so as to cover the single crystal silicon layer inward from an edge thereof;
growing an AlN film on the single crystal silicon layer; and
growing a GaN film or an AlGaN film, or both thereof on the AlN film.

FIG. 2 illustrates a schematic view of an example of an MOCVD apparatus that can be used for the inventive method for manufacturing a semiconductor substrate. The MOCVD apparatus has a satellite 2 having a pocket for placing the substrate, a ceiling 3 made of quartz, and a quartz 4.

The inventive method for manufacturing a nitride semiconductor substrate can epitaxially grow an AlN film, an AlGaN film, and a GaN film on a single crystal silicon substrate-on-insulative layer (substrate for film-forming) 1 in a rotation-revolution type MOCVD reaction furnace as illustrated in FIG. 2, for example. The single crystal silicon substrate-on-insulative layer (substrate for film-forming) 1 can be placed in a wafer pocket called as the satellite 2, as illustrated in FIG. 2 for example.

For this single crystal silicon substrate-on-insulative layer 1, a supporting substrate and a single crystal silicon substrate for laminating are bonded via a silicon oxide layer, and then the single crystal silicon substrate for laminating is thinned to be processed into a single crystal silicon layer. For example, the supporting substrate composed of a polycrystalline silicon substrate or a single crystal silicon substrate and the single crystal silicon substrate for laminating are preferably bonded via the silicon oxide layer, and then the single crystal silicon substrate for laminating is preferably processed to be thin to form the single crystal silicon layer.

A method for thinning the single crystal silicon substrate for laminating is not particularly limited, and conventional methods can be applied. For example, after the supporting substrate and the single crystal silicon substrate for laminating are bonded via the silicon oxide layer, grinding, polishing, or etching can be performed from the surface of the single crystal silicon substrate for laminating to achieve the thinning. Alternatively, usable is a so-called ion-implanting peeling method in which an ion-implanting layer is formed on the single crystal silicon substrate for laminating and peeled with the ion-implanting layer after the bonding.

For the epitaxial growth, trimethylaluminum (TMAl) as an Al source, TMGa as a Ga source, and NH₃ as a N source can be used, for example. The carrier gas can be N₂ and H₂, or any one thereof, and the process temperature is preferably, for example, approximately 900 to 1200°C. The carrier gas can be flown along a direction of a gas flow 5, and the flow rate can be regulated with a mass flow controller, etc.

In this time, a ring-shaped member 6 is placed so as to cover the single crystal silicon layer 13 inward from an edge thereof. For example, it is acceptable that the single crystal silicon substrate-on-insulative layer (substrate for film-forming 10) is placed in the satellite, and the ring-shaped member 6 is placed on the silicon substrate-on-insulative layer. The ring-shaped member 6 is placed so as to cover the region with the single crystal silicon layer 13 of the silicon substrate-on-insulative layer (the substrate for film-forming 10), for example, 0.3 mm or longer and shorter than 3 mm from the edge. Thereafter, a lid is closed to perform the epitaxial growth.

In this time, an AlN film is grown on the single crystal silicon layer 13, and a GaN film or an AlGaN film, or both thereof are grown on the AlN film. In the epitaxial layer, the AlN film and the AlGaN film can be formed in this order along the growing direction from the substrate side, and thereafter the GaN film can be epitaxially grown, for example. The structure of the epitaxial layer is not limited thereto. The AlGaN film is not formed, or the AlN film is further formed after forming the AlGaN film in some cases.

FIG. 1 illustrates a positional relationship between the single crystal silicon layer 13 and the GaN layer 14 in the case where the AlN film and the GaN film are grown in this order on the single crystal silicon substrate-on-insulative layer. "A" in FIG. 1 represents the range not to grow the GaN film 14 by placing the ring-shaped member.

Here, FIG. 4 shows a relationship between a change in the width of A and a number of generated reaction marks. As understood from FIG. 4, no reaction mark is generated by setting the width of A to be 0.3 mm or longer. The upper limit is preferably shorter than 3 mm with considering the device yield due to a reduction in the area of the GaN layer.

A material of the ring-shaped member 6 is not particularly limited as long as it is a material durable against the reaction at a high temperature, but SiC, which causes little consumption and is almost permanently usable, is preferably used. This yields a cost merit.

### EXAMPLE

Hereinafter, the present invention will be specifically described by using Example and Comparative Example, but the present invention is not limited thereto.

### (Example)

Set in the satellite 2 of the MOCVD apparatus illustrated in FIG. 2 was a substrate for film-forming 10 in which a single crystal silicon layer 13 is formed above a supporting substrate 11 composed of a single crystal silicon substrate with 150 mm in diameter via a silicon oxide layer 12. A ring-shaped member 6 composed of SiC was placed on the substrate for film-forming so as to cover a region with 0.3 mm from an edge of the single crystal silicon layer 13 of the substrate for growth.

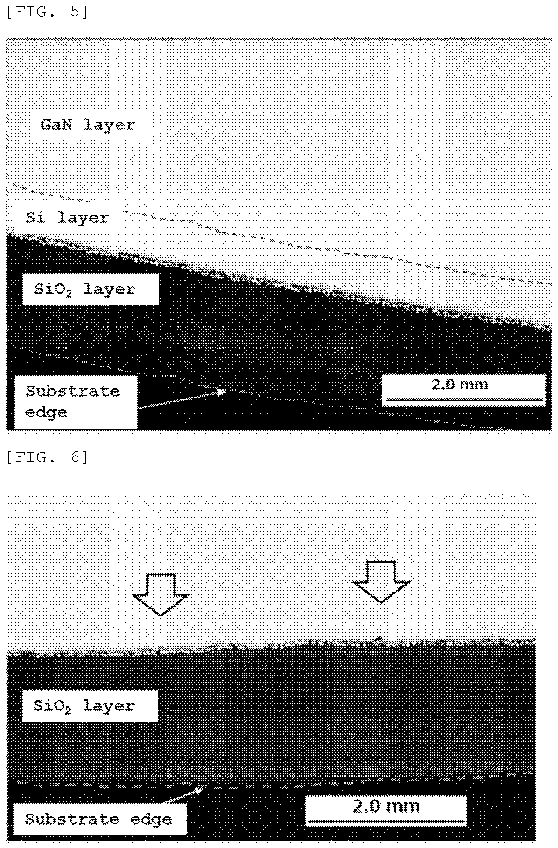

An AlN film with 100 nm in thickness was grown thereon. Thereafter, an AlGaN layer was grown with 150 nm. A GaN layer was grown thereon, and a total thickness of the epitaxial layer was 5 um. After the epitaxial growth was finished, a proximity of the edge of the single crystal silicon layer of the substrate for film-forming with the epitaxially grown GaN film was observed with an optical microscope to check a generation state of a reaction mark. FIG. 5 shows the result. As shown in FIG. 5, no reaction mark was generated.

### (Comparative Example)

An epitaxial growth was performed under the same condition as in Example except that the ring-shaped member was not placed. The generation state of a reaction mark on the periphery was checked in the same manner as in Example. FIG. 6 shows the result. As shown in FIG. 6, the generation of the reaction mark can be observed.

With comparing Example and Comparative Example, the inventive nitride semiconductor substrate can be a nitride semiconductor substrate with inhibited generation of the reaction mark.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A nitride semiconductor substrate, comprising a Ga-containing nitride semiconductor thin film formed on a substrate for film-forming in which a single crystal silicon layer is formed above a supporting substrate via an insulative layer, wherein the nitride semiconductor substrate has a region where the Ga-containing nitride semiconductor thin film is not formed inward from an edge of the single crystal silicon layer being a growth surface of the nitride semiconductor thin film.

2. The nitride semiconductor substrate according to claim 1, wherein the region where the film is not formed is a region with 0.3 mm or longer and shorter than 3 mm inward from the edge of the single crystal silicon layer.

3. The nitride semiconductor substrate according to claim 1 or 2, wherein the insulative layer is a silicon oxide (SiO₂) layer.

4. The nitride semiconductor substrate according to any one of claims 1 to 3, wherein the nitride semiconductor thin film formed on the substrate for film-forming has: an AlN film; and a GaN film or an AlGaN film, or a both thereof formed on the AlN film.

5. The nitride semiconductor substrate according to any one of claims 1 to 4, wherein the substrate for film-forming has: polycrystalline silicon or single crystal silicon as the supporting substrate; and the single crystal silicon layer laminated above the supporting substrate via a silicon oxide layer.

6. A method for manufacturing a nitride semiconductor substrate, the method comprising steps of:
preparing at least a supporting substrate and a single crystal silicon substrate for laminating;
bonding the supporting substrate and the single crystal silicon substrate for laminating via a silicon oxide layer;
thinning the single crystal silicon substrate for laminating to be processed into a single crystal silicon layer;
placing a ring-shaped member so as to cover the single crystal silicon layer inward from an edge thereof;
growing an AlN film on the single crystal silicon layer; and
growing a GaN film or an AlGaN film, or both thereof on the AlN film.

7. The method for manufacturing a nitride semiconductor substrate according to claim 6, wherein the supporting substrate is a supporting substrate composed of polycrystalline silicon or single crystal silicon.
